## Europäisches Patentamt

## European Patent Office

## Office européen des brevets

(19)

(11) Veröffentlichungsnummer: **0 075 036**
**B1**

(12) **EUROPÄISCHE PATENTSCHRIFT**

(45) Veröffentlichungstag der Patentschrift:
**15.10.86**

(51) Int. Cl.⁴: **H 01 L 23/46**

(21) Anmeldenummer: **81107465.7**

(22) Anmeldetag: **19.09.81**

(54) **Leistungshalbleiterbauelement für Flüssigkeitskühlung.**

(43) Veröffentlichungstag der Anmeldung:
**30.03.83 Patentblatt 83/13**

(45) Bekanntmachung des Hinweises auf die Patenterteilung:
**15.10.86 Patentblatt 86/42**

(84) Benannte Vertragsstaaten:
**CH DE FR GB IT LI SE**

(56) Entgegenhaltungen:
**WO-A-79/01012**
**DE-A-2 705 476**
**DE-A-2 716 066**
**DE-A-2 951 521**

(73) Patentinhaber: **BROWN, BOVERI & CIE Aktiengesellschaft Mannheim, Kallstadter Strasse 1, D-6800 Mannheim Käfertal (DE)**

(72) Erfinder: **Klein, Erwin, Dresdnerstrasse 5, D-6805 Heddesheim (DE)**

(74) Vertreter: **Kempe, Wolfgang, Dr., c/o BROWN, BOVERI & CIE AG Kallstadter Strasse 1 Postfach 351, D-6800 Mannheim 31 (DE)**

## Beschreibung

Die Erfindung bezieht sich auf ein Leistungshalbleiterbauelement für Flüssigkeitskühlung gemäß dem Oberbegriff des Anspruches 1.

Ein solches Leistungshalbleiterbauelement für Flüssigkeitskühlung ist aus der DE-A-27 15 055 bekannt. Ein wassergekühltes Leistunghalbleiterbauelement besteht aus einer Scheibenzelle mit Isoliergehäuse und mit elektrischer und thermischer Kontaktierung der Halbleiterscheibe. Zwei beidseitig der Halbleiterscheibe angeordnete, flüssigkeitsdurchströmte Kühldosen sind an deren beiden Hauptoberflächen angedrückt und sind zusammen mit der Halbleiterscheibe in das elektrisch isolierende, mit Durchführungen für äußere elektrische Anschlüsse versehene, erweiterte Isoliergehäuse integriert. Das Isoliergehäuse besitzt gemeinsame externe hydraulische Anschlüsse für die Zuführung sowie die Abführung der Kühlflüssigkeit, an die sich ein- und austrittsseitig im Isoliergehäuse nach unten und oben und weiterhin in Höhe der Kühldosen zunächst anschlußfrei bezüglich der Kühldosen, in zur Scheibenebene senkrechten Mittelachse etwa konzentrische Kanalbögen mit einem Bogenwinkel kleiner als 90° und oben und unten in entgegengesetzter Richtung und daran nach unten bzw. nach oben führende Kanalteile anschließen, denen unten bzw. oben konzentrische, zur jeweiligen Anschlußstelle zurückführende aber nicht an dieselbe angeschlossene Kanalbögen folgen, die schließlich über die parallelen und geraden Kühlkanalabschnitte an die Kühldosen angeschlossen und somit miteinander verbunden sind.

Bei dieser bekannten Anordnung ist es jedoch schwierig, einen gleichmäßigen elektrischen und thermischen Übergangswert zwischen Kühldosen und Halbleiterscheibe zu erreichen; die Halbleiterscheibe liegt zwischen zwei gleichen Kühldosen, die gegen die Haltleiterscheibe gepreßt werden. Bei diesem Aufbau kann der Übergangswert nicht immer gleich gehalten werden. Außerdem ist es wünschenswert, den thermischen und elektrischen Widerstand zwischen der Haltleiterscheibe und der äußeren Ableitung klein zu halten, damit die Wärme leicht nach außen über die Kühldose abfließen kann und der elektrische Widerstand soll klein sein, damit hier nicht noch zusätzliche Verlustwärme entsteht, die ebenfalls abgeführt werden muß.

Daher liegt der Erfindung die Aufgabe zugrunde, bei einem Leistungshalbleiterbauelement für Flüssigkeitskühlung der eingangs genannten Art die elektrische und thermische Übertragung von der Halbleiterscheibe bis zum weiterführenden elektrischen Kabel bzw. bis zur Kühldose zu verbessern, wobei eine Scheibenzellenbauart ohne kraftschlüssige Kontaktierung benutzt werden soll.

Diese Aufgabe wird durch die kennzeichnenden Merkmale des Anspruchs 1 gelöst.

Multikontakte sind an sich aus der DE-A-2 855 493, der DE-A-29 37 049 und der DE-A-29 38 095 bekannt. Bei dem in der zuletzt genannten Schrift dargestellten Leistungshalbleiterbauelement werden die Multikontakte vom Kühlmittel umströmt, während bei den beiden erstgenannten Schriften das Leistungshalbleiterbauelement mit Hilfe eines eigenen Gehäuses hermetisch abgedichtet ist. Eine detaillierte Ausführungsform eines derartigen Bauelementes speziell für Flüssigkeitskühlung mit einem nicht isolierenden Kühlmedium ist jedoch in keiner der genannten Schriften beschrieben.

In der WO-79/01012 ist zwar bereits ein Leistungshalbleiter-Bauelement für Flüssigkeitskühlung beschrieben, wobei die beiden Hauptelektroden der Halbleiterscheibe mittels thermisch und elektrisch leitenden Multikontakten kontaktiert sind und die Halbleiterscheibe mit ihren Kontakten in einem gegen die Kühlflüssigkeit hermetisch abgedichteten Gehäuse untergebracht ist. Bei dieser bekannten Anordnung erfolgt jedoch der elektrische Anschluß an den Außenwandungen der Kühldosen, so daß deren elektrischer Widerstand eine zusätzliche Verlustleistung bedingt.

Die mit der Erfindung erzielbaren Vorteile bestehen z. B. darin, daß keine kraftschlüssige Kontaktierung vorliegt und daher können die bei Erwärmung des Elementes im Betrieb aufgrund unterschiedlicher Ausdehnungskoeffizienten der stoffschlüssig verbundenen Teile auftretenden Relativbewegungen die Wechsellastfestigkeit der Elemente nicht mehr beeinträchtigen. Auch der thermische Widerstand des Bauelmentes ist vorteilhaft gering. Durch den vorgeschlagenen Gehäuseaufbau erfolgt eine Schub- und Zugentlastung der stoffschlüssigen Verbindungsstelle. Das Bauelement eignet sich insbesondere als Einzelbaustein eines aus vielen gleichartigen Leistungshalbleiterbauelmenten aufgebauten Blocks, wobei die Zugänglichkeit zu den einzelnen Bauelemten sehr gut ist (wichtig für den Austausch defekter Bausteine)

Vorteilhafte Ausgestaltungen der Erfindung sind in den Unteransprüchen gekennzeichnet.

Die Erfindung wird nachstehend anhand des in den Zeichnungen dargestellten Ausführungsbeispieles erläutert.

Es zeigen:

Fig. 1 das Leistungshalbleiterbauelement im Aufriß in zwei Schnitten,

Fig. 2 das Leistungshalbleiterbauelement im Grundriß in zwei Schnitten.

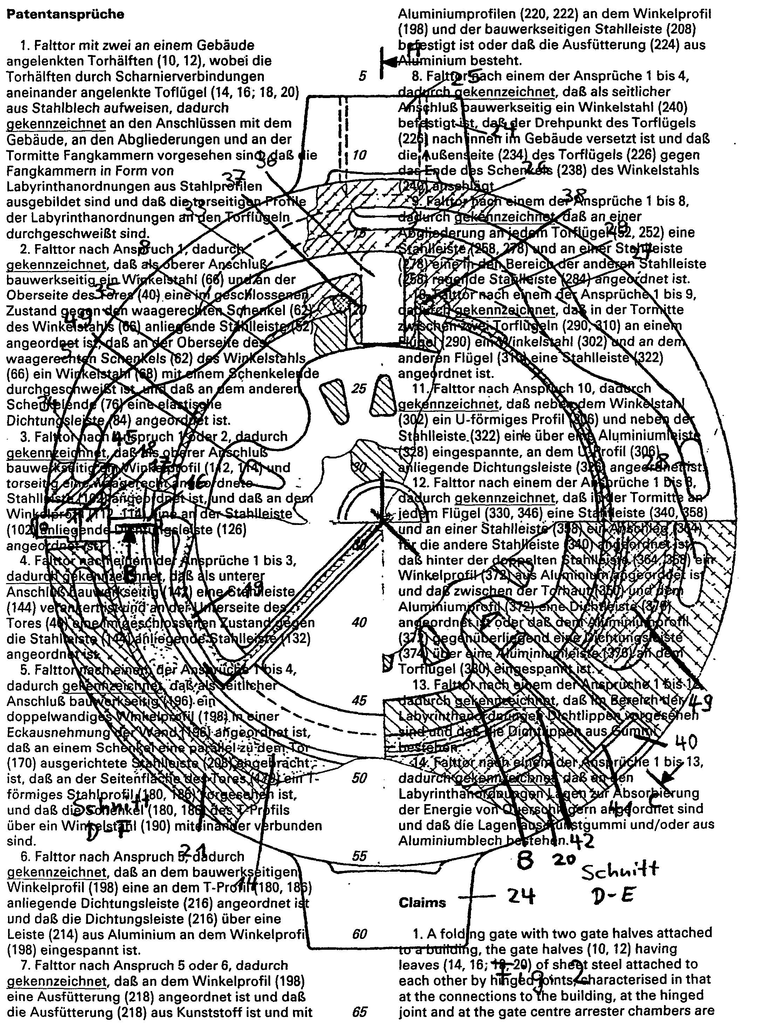

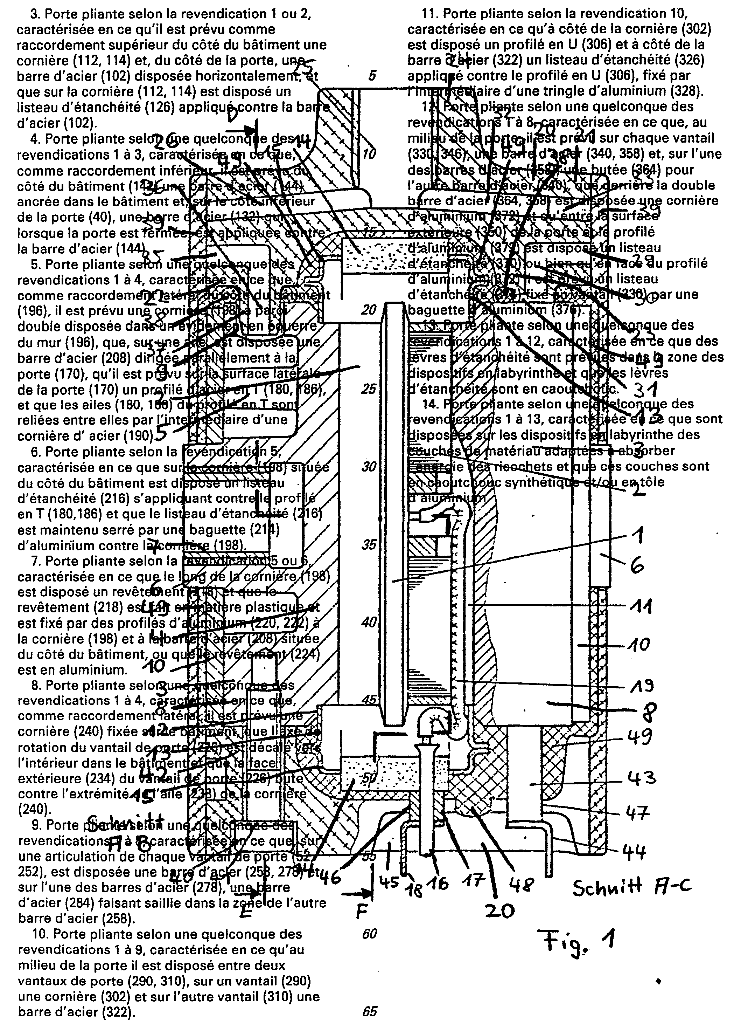

In Fig. 1 ist das Leistungshalbleiterbauelement im Aufriß in zwei Schnitten A-B und A-C dargestellt. Die jeweiligen Schnittlinien A,B und C sind dabei aus Fig. 2 ersichtlich.

Eine sich im Inneren des Leistungshalbleiterbauelementes befindende

2

Halbleiterkristallscheibe 1 ist über jede ihrer beiden Hauptelektroden stoffschlüssig mit Multikontakten 2 (Multifederkontakt) verbunden. An diese Multikontakte 2 schließen sich stoffschlüssig je eine Kühldose 3 an. Die Kühldosen 3 bestehen aus einem Boden 4, an dem Kühlstäbchen 5 und ein elektrisches Anschlußauge 5 mit Innengewinde 7 zum elektrischen Anschluß des Leistungshalbleiterbauelementes angeformt sind. Die Kühldosen 3 besitzen ferner eine Wandung 8 mit zwei Öffnungen 9 und einen stoffschlüssig aufgebrachten Deckel 10. Im Boden 4 der Kühldosen 3 ist eine Nut 11 angebracht. Bei Ausführung des Leistungshalbleiterbauelementes als Thyristor ist eine Gate-Anschlußleitung 19 in die Nut 11 eingelegt. Außerdem besitzt der Boden 4 der Kühldosen 3 eine Eindrehung 12, an der eine Membrane 13 stoffschlüssig befestigt ist.

Diese zu einer Baugruppe gefügten Teile werden in ein Gehäuse, bestehend aus einem Keramikring 14 mit stoffschlüssig angefügtem Kragen 15 eingebracht. Dabei wird die bereits erwähnte Gate-Anschlußleitung 19 in einen den Keramikring 14 durchstoßenden Pumpstutzen 15, der über ein Distanzröhrchen 17 mit einem elektrischen Steckerstift 18 in Verbindung steht, zum späteren elektrischen Anschluß eingeführt. Membrane 13 und Kragen 15 werden nach der Montage stoffschlüssig verbunden.

Nach diesem Vorgang wird ein Gehäuse, z.B. aus einem thermoplastischen Material, in Form zweier spiegelbildlich ausgeführter Halbschalen 20 über die bereits aufgebaute Baugruppe geschoben und an den Kühldosen 3 befestigt. Die Halbschalen 20 bestehen aus einer Wandung 21 mit je einem oben und unten nach innen sich erstreckenden Bord 22 und 23 und einem nach außen ragenden hydraulischen Anschlußauge 24. Als "oberer" Teil des Leistungshalbleiterbauelementes wird dabei der in Fig. 1 links von der Halbleiterkristallscheibe 1 angeordnete Teil bezeichnet, als "unterer" Teil der rechts von der Halbleiterkristallscheibe angeordnete Teil. Im Anschlußauge 24 ist eine Bohrung 25 mit Innengewinde zum Anschluß einer hydraulischen Kühlmittelleitung angebracht.

Von der Bohrung 25 aus erstreckt sich ein Kanal 26 nach oben und mündet in eine Rinne 27 (siehe hierzu Fig. 2). Diese führt über etwa einen Viertelkreis zu einem nach unten führenden Kanal 28 (siehe hierzu Fig. 2) der seinerseits in eine Rinne 29 mündet. Diese führt um den gleichen Winkelweg zurück zu einer Öffnung 30 einer nach innen in die Öffnung 9 der unteren Kühldose 3 ragende Tülle 31.

Von der Bohrung 25 führt ein gleichartiger Flüssigkeitspfad nach unten über einen Kanal 32, eine Rinne 33, einen Kanal 34 (siehe hierzu Fig. 2), eine Rinne 35 sowie eine Öffnung 36 einer Tülle 37, welche in eine Öffnung 9 der oberen Kühldose 3 ragt.

Die Dichtung der Tüllen 31/37 zu den Kühldosen 3 wird durch Rundschnurringe 38 vorgenommen. Die Rinnen 27/29 (siehe Fig. 2) und 33/35 (siehe Fig. 2) werden durch Aufbringen von zwei halbkreisförmigen Lochscheiben 39 aus Isolierstoff auf die Borde 22/23 und deren stoffschlüssiger Verbindung zu dichten Kanälen. Mit den Lochscheiben 39 werden auch die Kühldosen 3 bis auf die elektrischen Anschlußaugen 6 isolierend abgedeckt. Durch die beschriebene Kanalführung wird eine Leitungslänge erzielt, die es erlaubt, trotz großer Sperrspannung am Leistungshalbleiterbauelement mit Wasser als Kühlmittel zu arbeiten.

Durch das beschriebene Kanalsystem werden die beiden Kühldosen 3 des Leistungshalbleiterbauelementes über das hydraulische Anschlußauge 24 mit Kühlflüssigkeit versorgt, d.h. es wird Kühlflüssigkeit in den Kühldoseninnenraum geleitet. Die Ableitung der durch die Verlustwärme der Halbleiterkristallscheibe 1 erwärmte Kühlflüssigkeit erfolgt in gleicher Art und Weise über nicht dargestellte gleich aufgebaute Kanäle, Rinnen und Öffnungen zum zweiten hydraulischen Anschluß 24. Der Wärmetransport erfolgt von der erhitzten Halbleiterkristallscheibe 1 über die Multikontakte 2 zum Kühldosenboden 4 und zu den Kühlstäbchen 5. Über die Kühldosenstäbchen 5 und die Kühldosenwandung 8 wird auch der Kühldosendeckel 10 erwärmt. Die Kühlflüssigkeit umspült die Kühlstäbchen 5 und beaufschlagt ebenso den Boden 4, die Wandung 8 und den Deckel 10 der Kühldose 3.

Die Kühlflüssigkeit beaufschlagt die Multikontakte 2 nicht direkt, da diese durch den Kühldosenboden, die Membranen 13, die Kragen 15 und den Keramikring 14 gegenüber der Kühlflüssigkeit abgedichtet sind.

Die Befestigung der Halbschalen 20 an der Kühldose 3 erfolgt über mehrere Schrauben 40 mit Sicherungselementen 41. Dazu sind an der Wandung 21 der Halbschalen 20 nach innen ragende Augen 42 (siehe hierzu Fig. 2) angebracht. Mittels dieser Verschraubungen erfolgt eine Entlastung von eventuell auf die Lötstellen der Multikontakte 2 einwirkenden Kräften.

Bei einem als Thyristor ausgebildeten Leistungshalbleiterbauelement wird neben dem Gate-Anschluß zweckmäßigerweise auch ein Kathoden-Hilfsanschluß herausgeführt. Dies geschieht durch ein mit der Kühldose 3 stoffschlüssig verbundenes, die Wandung 21 der Halbleiterschale 20 durchstoßendes Stäbchen 43, auf dem ein Flachstecker 44 aufgebracht ist.

Gate- und Kathoden-Anschluß werden an den Trennstellen der beiden Halbschalen 20 nach außen geführt, wozu in diese eine Vertiefung 45 und zwei halbkreisförmige Aussparungen 46/47 eingebracht sind.

Nach dem Aufbringen und Befestigen der Halbschalen 20 auf die bereits aufgebaute Baugruppe wird durch eine Öffnung 48 in der Halbschale 20 im Bereich der Vertiefung 45 ein geschlossenporiger isolierender Füllstoff 49 eingespritzt. Eine der Öffnung 48 diametral gegenüberliegende, nicht dargestellte Öffnung erlaubt der Luft während des Füllvorganges auszutreten und ermöglicht eine Kontrolle über den Füllzustand des Stoffes 49.

Durch das Einbringen des Füllstoffes 49 werden zwei Effekte erzielt. Zum einen wird verhindert, daß durch sukzessive Verschmutzung und/oder Betauung des Keramikringes 14 die Isolierfähigkeit des Leistungshalblleiterelementes beeinträchtigt wird, zum anderen wird die Flüssigkeitsdichtung in Kühldose 3 und Tüllen 31/37 dauerhaft gesichert.

In Fig. 2 ist das Leistungshalbleiterbauelement im Grundriß in zwei Schnitten D-E und D-F dargestellt. Die jeweiligen Schnittlinien D, E und F sind dabei aus Fig. 1 ersichtlich. Insbesondere ist aus Fig. 2 die Kanalführung Bohrung 25 des hydraulischen Anschlußauges 24 - oberer Kanal 26 - obere Rinne 27 - Kanal 28 nach unten - untere Rinne 29 sowie die Kanalführung untere Rinne 33 - Kanal 34 nach oben - obere Rinne 35 - obere Öffnung 36 der Tülle 37 ersichtlich. Desweiteren sind die Kühlstäbchen 5 sowie die Wandung 8 der Kühldosen 3, die das Auge 42 der Halbschale 20 durchstoßende Schraube 40 mit Sicherungselement 41, die Gate-Anschlußleitung 19 mit Pumpstutzen 16, Distanzröhrchen 17 sowie die elektrischen Steckerstifte 18, die Wandung 21 mit Vertiefung 45, der Keramikring 14, die Rundschnurringe 38 sowie der Füllstoff 49 dargestellt.

**Patentansprüche**

1. Leistungshalbleiterbauelement für Flüßsigkeitskühlung mit einer mindestens einen pn-Übergang aufweisenden Halbleiterkristallscheibe (1), deren beide Hauptelektroden über thermisch und elektrisch leitende Kontakte (2) mit ebenfalls thermisch und elektrisch leitenden Bodenplatten (4) von Kühldosen (3) verbunden sind, wobei die Bodenplatten in Verbindung mit einem umlaufenden Keramikring (14) und weiteren ringförmigen Teilen ein flüssigkeitsdichtes, von einer Kühlflüssigkeit umströmbares Gehäuse für die Halbleiterkristallscheibe (1) bilden, in dem vom Kühlmedium durchströmbaren Innenraum der Kühldosen (3) Kühlstäbchen (5) angeordnet die Kühldosen (3) mit Öffnungen (9) für den Kühlmittelein- und auslaß versehen sind und als äußeres isolierendes Gehäuse zwei Halbschalen (20) mit hydraulischen Anschlußaugen vorgesehen sind, die ein verzweigtes Kanalsystem (26 bis 31 und 32 bis 37) von den Bohrungen (25) der Anschlußaugen (24) zu den Kühldosen-Öffnungen (9) aufweisen, <u>dadurch gekennzeichnet</u>, daß als elektrisch und thermisch leitende Kontakte zwischen den Hauptelektroden der Halbleiterscheibe (1) und den Bodenplatten (4) der Kühldosen (3) Multikontakte (2) vorgesehen sind und an dem jeweils dem Innenraum der Kühldosen (3) zugewandten Teil der Kühldosen-Bodenplatten (4) ein elektrisches Anschlußauge (6) mit Innengewinde (7) angeformt ist, wobei das Anschlußauge (6) mit Innengewinde (7) durch den Kühldosen-Innenraum hindurch nach außen geführt ist und ein Kühldosen-Deckel (10) mit einer für das elektrische Anschlußauge (6) vorgesehenen abdichtenden Öffnung den Kühldosen-Innenraum nach außen abschließt, und die Halbschalen (20) parallel zur Deckeloberfläche mit halbkreisförmigen, isolierenden Lochscheiben (39) abgedeckt sind, wobei die Lochscheiben (39) die Rinnen des Kanalsystems (27, 29, 33, 35) abdecken, jedoch die elektrischen Anschlußaugen (6) aussparen.

2. Leistungshalbleiterbauelement nach Anspruch 1, dadurch gekennzeichnet, daß von der Bohrung (25) jedes hydraulischen Anschlußauges (24) zwei seitliche Kanäle (26, 32) abzweigen, die in paralell zu den Scheibenoberflächen angeordneten Rinnen (27, 33) münden, die über senkrecht hierzu gelegene Kanäle (28, 34) mit auf der jeweils gegenüberliegenden Scheibenoberfläche angeordneten weiteren Rinnen (29, 35) verbunden sind, die über Öffnungen (30, 36) und Tüllen (31, 37) in die Kühldosen (3) führen, wobei zur Abdichtung zwischen den Tüllen (31, 37) und den Öffnungen (9) der Kühldosen (3) Rundschnurringe (38) vorgesehen sind.

3. Leistungshalbleiterbauelement nach einem der vorstehenden Ansprüche, dadurch gekennzeichnet, daß der Keramikring (14) über ringförmige Kragen (15) und ringförmige Membranen (13) mit den Kühldosen (3) verbunden ist.

4. Leistungshalbleiterbauelement nach Anspruch 3, dadurch gekennzeichnet, daß der Kühldosen-Boden (4) mit einer Eindrehung (12) zur Aufnahme der Membrane (13) versehen ist.

5. Leistungshalbleiterbauelement nach einem der vorstehenden Ansprüche, dadurch gekennzeichnet, daß der von Kühldosen (3) Halbschalen (20) und flüssigkeitsdichtem Gehäuse begrenzten Raum mit einem Füllstoff (40) versehen ist.

6. Leistungshalbleiterbauelement nach einem der vorstehenden Ansprüche, dadurch gekennzeichnet, daß die Halbschale (20) über Schrauben (40) mit den Kühldosen (3) verbunden sind.

7. Leistungshalbleiterbauelement nach einem der vorstehenden Ansprüche, dadurch gekennzeichnet, daß eine interne Gate-Anschlußleitung (19) einerseits über eine Nut (11) im Kühldosen-Boden (4) und eine Bohrung im Multikontakt (2) mit dem Steueranschluß der Halbleiterkristallscheibe (1), andererseits über einen Pumpstutzen (16) durch den Keramikring (14) mit einem externen elektrischen Steckerstift (18) verbunden ist.

8. Leistungshalbleiterbauelement nach einem der vorstehenden Ansprüche, dadurch gekennzeichnet, daß ein externer Hilfsanschluß über ein die Halbschalen (20) durchstoßendes, mit der Kühldose (3) stoffschlüssig verbundenes Stäbchen (43) vorgesehen ist.

## Claims

1. Power semiconductor component for liquid cooling, comprising a semiconductor crystal wafer (1) having at least one pn junction, the two main electrodes of which are connected via thermally and electrically conducting contacts (2) to also thermally and electrically conducting bottom plates (4) of cooling boxes (3) in which arrangement the bottom plates (4), in conjunction with a peripheral ceramic ring (14) and other annular parts form a fluid-tight housing for the semiconductor crystal wafer (1) around which housing a cooling fluid can flow, in the internal space, through which the cooling medium can flow, of the cooling boxes (3) small cooling rods (5) are arranged, the cooling boxes (3) are provided with openings (9) as coolant inlet and outlet and as an outer insulating housing two half-shells (20) with hydraulic connecting eyes (24) are provided which have a branched duct system (26 to 31 and 32 to 37) from the holes (25) of the connecting eyes (24) to the cooling box openings (9), characterized in that multicontacts (2) are provided as electrically and thermally conducting contacts between the main electrodes of the semiconductor wafer (1) and the bottom plates (4) of the cooling boxes (3) and an electric connecting eye (6) with internal thread (7) is moulded of one piece with the part of the cooling box bottom plates (4) facing in each case towards the internal space of the cooling boxes (3), in which arrangement the connecting eye (6) with internal thread (7) is passed through the internal space of the cooling box to the outside and a cooling box cover (10) having a sealing opening provided for the electric connecting eye (6) closes the internal space of the cooling box to the outside, and the halfshells (20) are covered parallel to the surface of the cover with semicircular insulating washers (39), in which arrangement the washers (39) cover the grooves of the duct system (27, 29, 33, 35) but leave an opening for the electrical connecting eyes (6).

2. Power semiconductor component according to Claim 1, characterized in that from the hole (25) of each hydraulic connecting eye (24) two lateral ducts (26, 32) branch off which open into grooves (27, 33) which are arranged parallel to the washer surfaces and which are connected via ducts (28, 34) situated perpendicur thereto to further grooves (29, 35) which are arranged on the respectively opposite washer surface and lead via openings (30, 36) and nozzles (31, 37) into the cooling boxes (3), 0-rings (38) being provided for sealing between the nozzles (37, 37) and the openings (9) of the cooling boxes (3).

3. Power semiconductor component according to one of the preceding claims, characterized in that the ceramic ring (14) is connected via annular collars (15) and annular membranes (13) to the cooling boxes (3).

4. Power semiconductor component according to Claim 3, characterized in that the cooling box bottom (4) is provided with a recess (12) for accommodating the membrane (13).

5. Power semiconductor component according to one of the preceding claims, characterized in that the space delimited by cooling boxes (3), half-shells (20) and fluid-tight housing is provided with a filling material (40).

6. Power semiconductor component according to one of the preceding claims, characterized in that the halfshells (20) are connected via screws (40) to the cooling boxes (3).

7. Power semiconductor component according to one of the preceding claims, characterized in that an internal gate connection line (79) is connected, on the one hand, via a groove (11) in the cooling box bottom (4) and a hole in the multicontact (2) to the gate-control connection of the semiconductor crystal wafer (1) and, on the other hand, via a pumping stud (16) through the ceramic ring (74) to an external electric plug pin (18).

8. Power semiconductor component according to one of the preceding claims, characterized in that an external auxiliary connection is provided via a small rod (43) which penetrates through the half-shells (20) and is integrally joined to the cooling box (3).

## Revendications

1. Composant semiconducteur de puissance pour refroidissement par liquide, comprenant une plaquette de cristal semiconducteur (1) qui présente au moins une jonction pn et dont les deux électrodes principales sont raccordées, par des contacts (2) thermiquement et électriquement conducteurs, à des plaques de fond (4), également thermiquement et électriquement conductrices, de boîtiers de refroidissement (3), les plaques de fond (4), en liaison avec un anneau en céramique circulaire (14) et d'autres éléments annulaires, formant pour la plaquette de cristal semiconducteur (1), un logement étanche au liquide et entouré par un liquide de refroidissement en circulation, des petits barreaux de refroidissement (5) étant disposés dans l'espace interne des boîtiers de refroidissement (3) parcouru par le réfrigérant, les boîtiers de refroidissement (3) étant munis d'ouvertures (9) pour l'entrée et la sortie du réfrigérant et comme enveloppe isolante extérieure étant prévues deux demi-coques (20) équipées de raccordements hydrauliques (24) et comportant un système de canaux ramifié (26 à 31 et 32 à 37) allant des alésages (25) des oeillets de raccordement (24) aux ouvertures (9) des boîtiers de refroidissement, caractérisé par le fait que comme contacts électriquement et thermiquement conducteurs entre les électrodes arincipales de la plaquette (1) de semiconducteur et les plaques de fond (4) des boîtiers de refroidissement (3), il est prévu des multicontacts (2) et sur les parties des plaques de fond (4), respectivement situées du côté de l'espace interne des boîtiers de refroidissement (3), est façonné un oeillet de raccordement électrique (6) avec taraudage (7), l'oeillet de raccordement (6) avec taraudage (7) aboutissant à l'extérieur en traversant l'espace interne du boîtier de refroidissement, et un couvercle (10), muni d'une ouverture avec étanchéité prévue pour l'oeillet deraccordement électrique (6), ferment vis-à-vis de l'extérieur l'espace interne du boîtier de refioidissement, et les demi-coques (20), parallèlement à la surface du couvercle, sont recouvertes de plaques perforées isolantes semicirculaires (39), les plaques perforées (39) recouvrant les rigoles du système de canaux (27, 29, 33, 35), mais laissant libres les oeillets de raccordement électriques (6).

2. Composant semiconducteur de puissance selon la revendication 1, caractérisé par le fait que de l'alésage (25) de chaque oeillet de raccordement hydraulique (24) partent deux canaux latéraux (26, 32) qui débouchent dans des rigoles (27, 33) lesquelles, disposées parallèlement aux surfaces de la plaquette, sont raccordées par des canaux (28, 34), placés perpendiculairement aux premiers, à d'autres rigoles (29, 35) qui sont disposées sur les surfaces respectivement opposées de la plaquette et qui aboutissent par des orifices (30, 36) et des douilles (31, 37) dans les boîtiers de refroidissement (3), des anneaux toriques (33) étant prévus pour assurer l'étanchéité entre les douilles (31, 37) et les ouvertures (9) des boîtiers de refroidissement (3).

3. Composant semiconducteur de puissance selon l'une des revendications précédentes, caractérisé par le fait que l'anneau en céramique (14) est raccordé aux boîtiers de refroidissement (3) par des collets annulaires (15) et des membranes annulaires (13).

4. Composant semiconducteur de puissance selon la revendication 3, caractérisé par le fait que le fond (4) des boîtiers de refroidissement est muni d'une gorge (12) tournée dans la masse pour recevoir les membranes (13).

5. Composant semiconducteur de puissance selon l'une des revendications précédentes, caractérisé par le fait que l'espace délimité par les boîtiers de refroidissement, les demi-coques (20) et le logement étanche au liquide, est garni d'un matériau de remplissage (40).

6. Composant semiconducteur de puissance selon l'une des revendications précédentes, caractérisé par le fait que les demi-coques sont raccordées aux boîtiers de refroidissement (3) au moyen de vis (40).

7. Composant semiconducteur de puissance selon l'une des revendications précédentes, caractérisé par le fait qu'une ligne de raccordement-gâchette interne (19) est reliée, d'une part, par une rainure (11) du fond (4) du boîtier de refroidissement et par un perçage du multicontact (2), à la borne de commande de la plaquette de cristal semiconducteur (1), d'autre part, par une tubulure de pompe (16) traversant l'anneau en céramique (14), à une broche électrique externe (13).

8. Composant semiconducteur de puissance selon l'une des revendications précédentes, caractérisé par le fait qu'il est prévu un raccord auxiliaire externe au moyen d'un petit barreau (43) traversant les demi-coques (20) et raccordé par matière au boîtier de refroidissement (3).

## Patentansprüche

1. Falttor mit zwei an einem Gebäude angelenkten Torhälften (10, 12), wobei die Torhälften durch Scharnierverbindungen aneinander angelenkte Toflügel (14, 16; 18, 20) aus Stahlblech aufweisen, dadurch gekennzeichnet an den Anschlüssen mit dem Gebäude, an den Abgliederungen und an der Tormitte Fangkammern vorgesehen sind, daß die Fangkammern in Form von Labyrinthanordnungen aus Stahlprofilen ausgebildet sind und daß die torseitigen Profile der Labyrinthanordnungen an den Torflügeln durchgeschweißt sind.

2. Falttor nach Anspruch 1, dadurch gekennzeichnet, daß als oberer Anschluß bauwerkseitig ein Winkelstahl (66) und an der Oberseite des Tores (40) eine im geschlossenen Zustand gegen den waagerechten Schenkel (62) des Winkelstahls (66) anliegende Stahlleiste (52) angeordnet ist, daß an der Oberseite des waagerechten Schenkels (62) des Winkelstahls (66) ein Winkelstahl (68) mit einem Schenkelende durchgeschweißt ist, und daß an dem anderen Schenkelende (76) eine elastische Dichtungsleiste (84) angeordnet ist.

3. Falttor nach Anspruch 1 oder 2, dadurch gekennzeichnet, daß als oberer Anschluß bauwerkseitig ein Winkelprofil (112, 114) und torseitig eine waagerecht angeordnete Stahlleiste (102) angeordnet ist, und daß an dem Winkelprofil (112, 114) eine an der Stahlleiste (102) anliegende Dichtungsleiste (126) angeordnet ist.

4. Falttor nach einem der Ansprüche 1 bis 3, dadurch gekennzeichnet, daß als unterer Anschluß bauwerkseitig (142) eine Stahlleiste (144) verankert ist und an der Unterseite des Tores (40) eine im geschlossenen Zustand gegen die Stahlleiste (144) anliegende Stahlleiste (132) angeordnet ist.

5. Falttor nach einem der Ansprüche 1 bis 4, dadurch gekennzeichnet, daß als seitlicher Anschluß bauwerkseitig (196) ein doppelwandiges Winkelprofil (198) in einer Eckausnehmung der Wand (196) angeordnet ist, daß an einem Schenkel eine parallel zu dem Tor (170) ausgerichtete Stahlleiste (208) angebracht ist, daß an der Seitenfläche des Tores (40) ein T-förmiges Stahlprofil (180, 186) vorgesehen ist, und daß die Schenkel (180, 186) des T-Profils über ein Winkelstahl (190) miteinander verbunden sind.

6. Falttor nach Anspruch 5, dadurch gekennzeichnet, daß an dem bauwerkseitigen Winkelprofil (198) eine an dem T-Profil (180, 186) anliegende Dichtungsleiste (216) angeordnet ist und daß die Dichtungsleiste (216) über eine Leiste (214) aus Aluminium an dem Winkelprofil (198) eingespannt ist.

7. Falttor nach Anspruch 5 oder 6, dadurch gekennzeichnet, daß an dem Winkelprofil (198) eine Ausfütterung (218) angeordnet ist und daß die Ausfütterung (218) aus Kunststoff ist und mit Aluminiumprofilen (220, 222) an dem Winkelprofil (198) und der bauwerkseitigen Stahlleiste (208) befestigt ist oder daß die Ausfütterung (224) aus Aluminium besteht.

8. Falttor nach einem der Ansprüche 1 bis 4, dadurch gekennzeichnet, daß als seitlicher Anschluß bauwerkseitig ein Winkelstahl (240) befestigt ist, daß der Drehpunkt des Torflügels (226) nach innen im Gebäude versetzt ist und daß die Außenseite (234) des Torflügels (226) gegen das Ende des Schenkels (238) des Winkelstahls (240) anschlägt.

9. Falttor nach einem der Ansprüche 1 bis 8, dadurch gekennzeichnet, daß an einer Abgliederung an jedem Torflügel (252, 252) eine Stahlleiste (258, 278) und an einer Stahlleiste (278) eine in den Bereich der anderen Stahlleiste (258) ragende Stahlleiste (284) angeordnet ist.

10. Falttor nach einem der Ansprüche 1 bis 9, dadurch gekennzeichnet, daß in der Tormitte zwischen zwei Torflügeln (290, 310) an einem Flügel (290) ein Winkelstahl (302) und an dem anderen Flügel (310) eine Stahlleiste (322) angeordnet ist.

11. Falttor nach Anspruch 10, dadurch gekennzeichnet, daß neben dem Winkelstahl (302) ein U-förmiges Profil (306) und neben der Stahlleiste (322) eine über eine Aluminiumleiste (328) eingespannte, an dem U-Profil (306) anliegende Dichtungsleiste (326) angeordnet ist.

12. Falttor nach einem der Ansprüche 1 bis 8, dadurch gekennzeichnet, daß in der Tormitte an jedem Flügel (330, 346) eine Stahlleiste (340, 358) und an einer Stahlleiste (358) ein Anschlag (364) für die andere Stahlleiste (340) angeordnet ist, daß hinter der doppelten Stahlleiste (364, 358) ein Winkelprofil (372) aus Aluminium angeordnet ist und daß zwischen der Torhaut (350) und dem Aluminiumprofil (372) eine Dichtleiste (378) angeordnet ist oder daß dem Aluminiumprofil (372) gegenüberliegend eine Dichtungsleiste (374) über eine Aluminiumleiste (376) an dem Torflügel (380) eingespannt ist.

13. Falttor nach einem der Ansprüche 1 bis 12, dadurch gekennzeichnet, daß im Bereich der Labyrinthanordnungen Dichtlippen vorgesehen sind und daß die Dichtlippen aus Gummi bestehen.

14. Falttor nach einem der Ansprüche 1 bis 13, dadurch gekennzeichnet, daß an den Labyrinthanordnungen Lagen zur Absorbierung der Energie von Querschlägern angeordnet sind und daß die Lagen aus Kunstgummi und/oder aus Aluminiumblech bestehen.

## Claims

1. A folding gate with two gate halves attached to a building, the gate halves (10, 12) having leaves (14, 16; 18, 20) of sheet steel attached to each other by hinged joints, characterised in that at the connections to the building, at the hinged joint and at the gate centre arrester chambers are

3. Porte pliante selon la revendication 1 ou 2, caractérisée en ce qu'il est prévu comme raccordement supérieur du côté du bâtiment une cornière (112, 114) et, du côté de la porte, une barre d'acier (102) disposée horizontalement, et que sur la cornière (112, 114) est disposé un listeau d'étanchéité (126) appliqué contre la barre d'acier (102).

4. Porte pliante selon une quelconque des revendications 1 à 3, caractérisée en ce que, comme raccordement inférieur, il est prévu du côté du bâtiment (142) une barre d'acier (144) ancrée dans le bâtiment et, sur le côté intérieur de la porte (40), une barre d'acier (132) qui, lorsque la porte est fermée, est appliquée contre la barre d'acier (144).

5. Porte pliante selon une quelconque des revendications 1 à 4, caractérisée en ce que, comme raccordement latéral du côté du bâtiment (196), il est prévu une cornière (198), la paroi double disposée dans un évidement en équerre du mur (196), que, sur une aile est disposée une barre d'acier (208) dirigée parallèlement à la porte (170), qu'il est prévu sur la surface latérale de la porte (170) un profilé métallique en T (180, 186), et que les ailes (180, 186) du profilé en T sont reliées entre elles par l'intermédiaire d'une cornière d'acier (190).

6. Porte pliante selon la revendication 5, caractérisée en ce que sur la cornière (198) située du côté du bâtiment est disposé un listeau d'étanchéité (216) s'appliquant contre le profilé en T (180,186) et que le listeau d'étanchéité (216) est maintenu serré par une baguette (214) d'aluminium contre la cornière (198).

7. Porte pliante selon la revendication 5 ou 6, caractérisée en ce que le long de la cornière (198) est disposé un revêtement (218) et que le revêtement (218) est fait en matière plastique et est fixé par des profilés d'aluminium (220, 222) à la cornière (198) et à la barre d'acier (208) située du côté du bâtiment, ou que le revêtement (224) est en aluminium.

8. Porte pliante selon une quelconque des revendications 1 à 4, caractérisée en ce que, comme raccordement latéral, il est prévu une cornière (240) fixée sur le bâtiment, que l'axe de rotation du vantail de porte (226) est décalé vers l'intérieur dans le bâtiment et que la face extérieure (234) du vantail de porte (226) bute contre l'extrémité de l'aile (238) de la cornière (240).

9. Porte pliante selon une quelconque des revendications 1 à 8, caractérisée en ce que, sur une articulation de chaque vantail de porte (52, 252), est disposée une barre d'acier (258, 278) et sur l'une des barres d'acier (278), une barre d'acier (284) faisant saillie dans la zone de l'autre barre d'acier (258).

10. Porte pliante selon une quelconque des revendications 1 à 9, caractérisée en ce qu'au milieu de la porte il est disposé entre deux vantaux de porte (290, 310), sur un vantail (290) une cornière (302) et sur l'autre vantail (310) une barre d'acier (322).

11. Porte pliante selon la revendication 10, caractérisée en ce qu'à côté de la cornière (302) est disposé un profilé en U (306) et à côté de la barre d'acier (322) un listeau d'étanchéité (326) appliqué contre le profilé en U (306), fixé par l'intermédiaire d'une tringle d'aluminium (328).

12. Porte pliante selon une quelconque des revendications 1 à 8, caractérisée en ce que, au milieu de la porte, il est prévu sur chaque vantail (330, 346) une barre d'acier (340, 358) et, sur l'une des barres d'acier (358), une butée (364) pour l'autre barre d'acier (340), que derrière la double barre d'acier (364, 358) est disposée une cornière d'aluminium (372) et qu'entre la surface extérieure (350) de la porte et le profilé d'aluminium (372) est disposé un listeau d'étanchéité (374) ou bien qu'en face du profilé d'aluminium (372) est prévu un listeau d'étanchéité (374) fixé au vantail (330) par une baguette d'aluminium (376).

13. Porte pliante selon une quelconque des revendications 1 à 12, caractérisée en ce que des lèvres d'étanchéité sont prévues dans la zone des dispositifs en labyrinthe et que les lèvres d'étanchéité sont en caoutchouc.

14. Porte pliante selon une quelconque des revendications 1 à 13, caractérisée en ce que sont disposées sur les dispositifs en labyrinthe des couches de matériau adaptées à absorber l'énergie des ricochets et que ces couches sont en caoutchouc synthétique et/ou en tôle d'aluminium.

Schnitt A-C

Fig. 1